# EUROPEAN PATENT SPECIFICATION

(11) **EP 1 398 839 B1**
(45) Date of publication and mention of the grant of the patent: **28.03.2012**
(21) Application number: 02720561.6
(22) Date of filing: 22.04.2002
(51) Int. Cl.: H01L 33/38

(54) **LIGHT EMITTING DEVICE COMPRISING LIGHT EMITTING DIODE CHIP**
LICHTEMITTIERENDE EINRICHTUNG MIT EINEM LEUCHTDIODEN-CHIP
DISPOSITIF ELECTROLUMINESCENT COMPRENANT UNE PUCE DE DIODE ELECTROLUMINESCENTE

(30) Priority: 23.04.2001 JP 2001124556; 19.09.2001 JP 2001285893
(43) Date of publication of application: 17.03.2004
(73) Proprietor: Panasonic Corporation, Osaka 571-8501 (JP)
(72) Inventor: HASHIMOTO, Takuma, Kadoma-shi, Osaka 571-8686 (JP); SUGIMOTO, Masaru, Kadoma-shi, Osaka 571-8686 (JP); KIMURA, Hideyoshi, Kadoma-shi, Osaka 571-8686 (JP); SHIOHAMA, Eiji, Kadoma-shi, Osaka 571-8686 (JP); KUZUHARA, Itukou, Kadoma-shi, Osaka 571-8686 (JP); TAKAMI, Sigenari, Kadoma-shi, Osaka 571-8686 (JP)
(74) Representative: Schnekenbühl, Robert Matthias L.
(86) International application number: PCT/JP2002/004002
(87) International publication number: WO 2002/089221

(56) References cited:
- EP-A- 0 921 577
- EP-A- 1 030 377
- WO-A-01/47039
- GB-A- 2 343 994
- JP-A- 6 244 458
- JP-A- 7 288 340
- JP-A- 8 064 872
- JP-A- 10 200 156
- JP-A- 11 150 295
- JP-A- 61 134 085

## Description

### Technical Field

The present invention relates to a light emitting device using a light emitting diode (LED) chip that has n-type and p-type semiconductor layers formed on the crystals of a light-transmissive substrate and that is mounted face down on a mounting board.

### Background Art

Conventionally, semiconductor LED chips of gallium nitride group compounds (such as InGaN), for example, have the following construction in general. That is, such an LED chip is configured by an n-type gallium nitride layer (referred to as an n-type semiconductor layer hereinafter) formed on a light-transmissive sapphire substrate with a buffer layer of aluminum nitride, gallium nitride, or the like therebetween, multiple layers of quantum well structure (including a light emitting layer) formed thereon, and a p-type gallium nitride layer (referred to as a p-type semiconductor layer hereinafter) formed thereon. Additionally, a cap layer may be formed thereon for enhancing light extraction efficiency.

Sapphire to be used as a substrate is not electrically conductive. Therefore, part of both the p-type semiconductor layer and the light emitting layer are etched away so that the n-type semiconductor layer is partially exposed, on which an n-side electrode for the n-type semiconductor layer is formed. More particularly, gallium nitride group LED chips are generally configured to have two kinds of electrodes, i.e. n-side and p-side electrodes, at the side where semiconductor layers are formed. In general, a single circular or rectangular electrode with an area suitable for wire bonding is provided on each of the p-type and n-type layers. Gallium nitride group LED chips typically have each side of 300µm long and a thickness of 70µm; thus being as small as conventional LED chips.

When mounting on a light source apparatus such a gallium nitride group LED chip as described above, the LED chip is die bonded face up, i.e. with the side where semiconductor layers are formed facing toward the opposite direction to the mounting board of the light source apparatus, before connected at its two electrodes with the mounting board by wire bonding. In the mounting mode, the semiconductor layers made of gallium nitride of the LED chip generate heat, which is released through the sapphire substrate toward the outside.

In a manufacturing process of LED chips, gallium nitride layers (semiconductor layers) are first provided with a relatively thick light-transmissive substrate for enhancing the strength. Subsequently, the substrate is polished at the back side to the thickness of 70µm so as to be improved in the effect of heat radiation before each LED chip is cut out.

Meanwhile, in conventional LED chips, only one pair of p-side and n-side electrodes are provided. Therefore, it is only the area between the two electrodes of the LED chip that can emit light with a sufficient current flowing, while the other area cannot receive a current sufficiently thus being declined in the intensity of light emission.

Since conventional small LED chips having each side of 300 µm long are low in the ratio of the light emitting area to the area of electrodes, the variations of the intensity of light emission (the variations of currents) within the surface of the LED chip has not become a serious problem.

However, if it is required, as one of methods for increasing the light output of light source apparatus, to increase the size of the LED chip and to energize the chip with a large current in accordance with the size of the chip (the current density is the same as that in conventional chips), the ratio of the light emitting area to the electrode area becomes high to increase the variations of currents and thus the variations of the intensity of light emission within the surface of the LED chip.

If a large current is applied to the LED chip in which currents are flowing unevenly, the LED chip becomes liable to deteriorate at the area across which a large amount of current flows. The area in the chip surface most serving for light emission tends to deteriorate earliest, and thus the deterioration of the LED chip is promoted as a whole. The deterioration can be decreased if the total amount of current is lessen so that the current density at the area receiving a large amount of current does not exceed a rated value. In such a case, however, the amount of current flowing in other area of the LED chip becomes below its rating, thus decreasing the amount of light to be emitted in the other area. As a result, the LED chip is declined in the light output as a whole.

UK patent application GB 2343994 A describes a light emitting device 10 including a heterojunction having a p-type layer and an n-type layer. The n-electrode is electrically connected to the n-type layer while the p-electrode is electrically connected to the p-type layer. The p- and n-electrodes are positioned to form a region having uniform light intensity. The electrodes may be interdigitated or shaped as an annulus or have various shapes and positions in order to provide a uniform current density and therefore a uniform light intensity from the device.

The present invention has been developed in view of the foregoing drawbacks, and an object of the present invention is to provide a light emitting device that is improved in the uniformity of intensity of light emission in the light emitting surface while enhanced in the efficiency of light extraction from the LED chip (external quantum efficiency).

### Disclosure of the Invention

The present invention provides a light emitting device according to claim 1.

In the present invention, a plurality of first electrodes and a plurality of second electrodes are provided on the respective first and second semiconductor layers. This can provide increased area where the electrodes face each other, thus uniformizing the current density in the light emitting layer. Accordingly, the light-emitting surface in the light emitting device can be improved in the uniformity of intensity of light emission.

In the present invention, the plurality of first and second electrodes may be arranged alternately in parallel with each other at the side where the semiconductor layers are formed. This can uniformize the current density in the light emitting layer, thus allowing the light-emitting surface in the light emitting device to be improved in the uniformity of intensity of light emission. In the present invention, the electrodes may be arranged in parallel with each other at substantially regular intervals. This can make the current density in the light emitting layer still more uniform, thus allowing the light-emitting surface in the light emitting device to be further improved in the uniformity of intensity of light emission.

In the present invention, the first and second electrodes may be configured in a comblike structure. This can make the current density in the light emitting layer still more uniform, thus allowing the light-emitting surface in the light emitting device to be further improved in the uniformity of intensity of light emission.

In the present invention, a light reflecting member may be provided on a surface of the LED chip, separately from the electrodes. This can further improve the light extraction efficiency of the light emitting device.

In the present invention, either a surface of the mounting board that faces the LED chip or a filler applied to a space between the LED chip and the mounting board may be used as a light reflector. This can improve the light extraction efficiency of the light emitting device.

In the present invention, the mounting board may be a circuit board including a conductive plate having at least one surface provided with an insulating layer and an electrically conductive layer provided over the conductive plate with the insulating layer therebetween; and at least one of the electrodes of the LED chip may be electrically connected to the electrically conductive layer by the face down mounting, and a heat transfer medium that is higher in thermal conductivity than the insulating layer may be disposed between the LED chip and the conductive plate. By transferring heat generated by the LED chip to the conductive plate through the heat transfer medium, the effect of heat radiation of the LED chip can be improved. Thus, a rise in the temperature of the LED chip can be prevented when the LED chip is turned on, as compared to conventional structure. As a result, the LED chip can provide increased light output without declining its operating life. If the light output is remaining unchanged, the operating life can be improved as compared with conventional structure.

In the present invention, each of the electrodes of the LED chip may be connected to a respective electrically conductive layer. By this arrangement, the heat transfer medium can contribute to heat radiation, electrically independent of the electrodes of the LED chip. Therefore, even if the electrode is relatively small for the size of the LED, heat generated from the LED chip can be transferred to the conductive plate.

In the present invention, the heat transfer medium may be formed integral with the conductive plate. This can enhance the thermal coupling between the heat transfer medium and the conductive plate. Further, in the case where the electrode of the LED chip is joined with any other member by using a bump, there is about several tens µm gap between the LED and the member. It is assumed that the member is the electrically conductive layer formed over the conductive plate with the insulating layer therebetween. In such a case, the LED chip and the conductive plate are distant from each other by the gap and the thickness of both the electrically conductive layer and the insulating layer. That is, the distance is more than 100 µm. As a result, the thermal conductivity between the LED chip and the conductive plate is declined due to the long distance. Thus, the heat transfer medium is integrated with the conductive plate to decrease the distance between the LED chip and the conductive plate.

In the present invention, the heat transfer medium may be made of a metal. This can improve the thermal conductivity between the conductive plate and the LED.

In the present invention, the electrically conductive layer may be partially extended to the surface of the circuit board opposite the LED chip, for connection to an external circuit. This makes it easy to join the device with a circuit board provided separately by soldering or caulking.

The light-transmissive substrate of the LED chip in the present invention may have a roughened surface. According to the present invention, an LED chip can be provided that has increased luminous efficiency and lessened color shading.

Side surfaces of the light- transmissive substrate of the LED chip in the present invention may be cut at an oblique angle to serve as a mirror. According to the present invention, an LED chip can be provided that has increased luminous efficiency and lessened color shading.

### Brief Description of the Drawings

FIG. 1 is a cross sectional view of a light emitting device according to Embodiment 1 of the present invention.
FIG. 2 is a view showing an arrangement of electrode structure of an LED chip not forming part of the present invention.
FIG. 3 is a view showing another arrangement of electrode structure of an LED chip not forming part of the present invention.
FIG. 4 is a view showing still another arrangement of electrode structure of an LED chip not forming part of the present invention.
FIG. 5 is a view showing an arrangement of electrode structure of the LED chip according to the present invention.
FIG. 6 is a view showing another arrangement of electrode structure of the LED Chip according to the present invention.
FIG.7 is a view showing another arrangement of electrode structure of an LED chip not forming part of the present invention.
FIG. 8 is a view showing another arrangement of electrode structure of the LED chip not forming part of the present invention.
FIG.9 is a view showing another arrangement of electrode structure of the LED chip not forming part of the present invention.
FIG. 10 is a cross sectional view of the main part of the light emitting device according to Embodiment 1 of the present invention.
FIG. 11 is a cross sectional view showing the main part of an alternative of the same.
FIG. 12 is a cross sectional view of the main part of a light emitting device according to Embodiment 2 of the present invention.
FIG. 13 is a cross sectional view of an alternative LED chip in the device.
FIG. 14 is a cross sectional view of another alternative of an LED chip in the device.
FIGS. 15a and 15b are cross sectional views of alternative LED chips in the device.
FIG. 16 is a cross sectional view of an alternative LED chip in the device.
FIG. 17 is a cross sectional view of the main part of the device.
FIG. 18 is a cross sectional view of the main part of a light emitting device according to Embodiment 3 of the present invention.
FIG. 19 is a cross sectional view of the main part of a light emitting device according to Embodiment 4 of the present invention.
FIG. 20 is a cross sectional view showing the main part of an alternative of the same.
FIG. 21 is a cross sectional view showing the main part of another alternative of the same.
FIG. 22 is a cross sectional view of the main part of a light emitting device according to Embodiment 5 of the present invention.
FIG. 23 is a cross sectional view of the same.
FIG. 24 is a cross sectional view showing the main part of an alternative of the same.
FIG. 25 is a cross sectional view showing the main part of another alternative of the same.
FIG. 26 is a cross sectional view showing the main part of another alternative of the same.
FIG. 27 is a cross sectional view showing the main part of still another alternative of the same.
FIG. 28 is a cross sectional view of a chip portion of a light emitting device according to Embodiment 6 of the present invention.
FIGS. 29a and 29b are views showing a process of assembling the same.
FIG. 30 is a cross sectional view of an alternative of the same.
FIG. 31 is a cross sectional view of another alternative of the same.
FIG. 32 is a cross sectional view of another alternative of the same.
FIG. 33 is a cross sectional view showing the main part of another alternative of the same.
FIG. 34 is a cross sectional view showing the main part of still another alternative of the same.
FIG. 35 is a cross sectional view of a chip portion of a light emitting device according to Embodiment 7 of the present invention.
FIGS. 36a and 36b are views showing a process of assembling the same.
FIG. 37 is a cross sectional view of an LED chip portion according to Embodiment 8 of the present invention.
FIG. 38 is a cross sectional view of an LED chip portion according to Embodiment 9 of the present invention.
FIG. 39 is a cross sectional view of an LED chip portion according to Embodiment 10 of the present invention.
FIG. 40a is a plan view showing the semiconductor layer provided side of a conventional LED chip to be mounted face down, FIG. 40b is a sectional side elevation of the LED chip, and FIG. 40c is a cross sectional view of the LED chip mounted on a mounting board.
FIG. 41 is a cross sectional view of a light emitting device using a conventional LED chip to be mounted face down.

### Best Modes for embodying the Invention

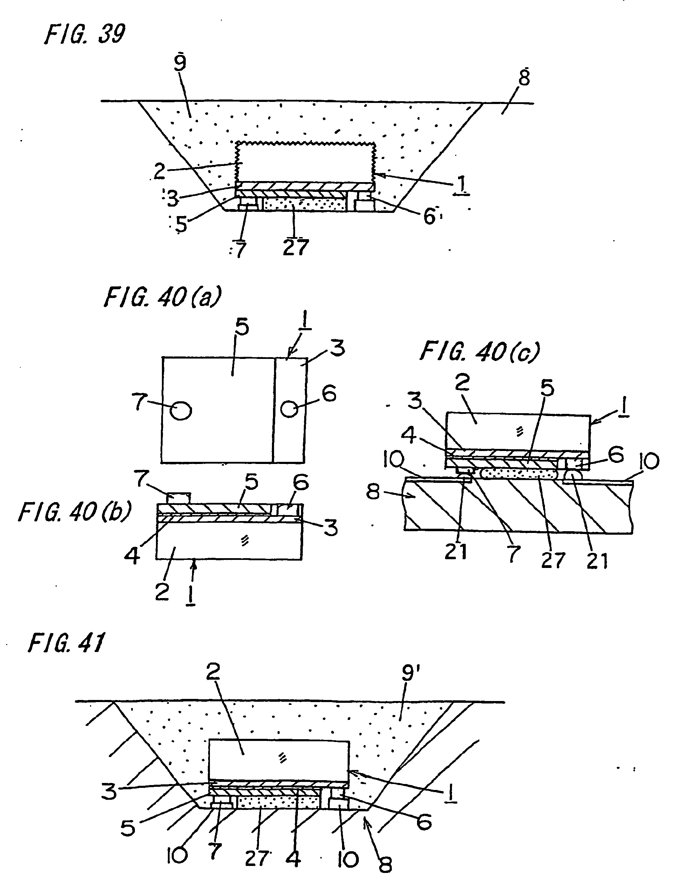

The description starts with an LED chip that is employed in a light emitting device and configured to be mounted face down, referring to FIG. 40. As shown in FIGS. 40a and 40b, an LED chip 1 comprises a gallium nitride group compound semiconductor that includes an n-type semiconductor layer 3 or n-type GaN layer formed on a light-transmissive substrate 2 of sapphire with a buffer layer (not shown) therebetween, a cladding layer (not shown), a light emitting layer 4, another cladding layer (not shown), and a p-type semiconductor layer 5 or p-type GaN layer, the layers being formed in the above order. The semiconductor is not limited to the gallium nitride group compound semiconductor, but other semiconductors can be used if the crystal of the substrate is capable of transmitting light. Further, the light-transmissive substrate is not limited to that of sapphire, but may be that of silicon carbide, for example.

The semiconductor layers 3 and 5 have an n-side electrode 6 and a p-side electrode 7 respectively formed thereon. As shown in FIG. 40c, the LED chip is disposed in a manner so that its side where the semiconductor layers 3 and 5 are formed faces a mounting board 8. A filler 27 is applied to the space between the mounting board 8 and the p-type semiconductor layer 5. Each of the electrodes 6 and 7 is soldered, with soldering bumps 21 and 21, to an electrically conductive material 10 provided at the mounting board 8. The LED chip is mounted by a face down mounting technique, with the light-transmissive substrate 2 side serving as the light-emitting surface. Then, by disposing the LED chip within a fluorescent material layer 9' that can be excited by near ultraviolet rays so as to develop yellow color light, a light source apparatus is provided that can emit white color light by blue color light emitted from the LED chip 1 being combined with the yellow color light developed by the fluorescent material layer 9'.

The light emitting device of the present invention uses the LED chip 1 configured in such a manner as described above. Now, some embodiments of the present invention will be described.

### (Embodiment 1)

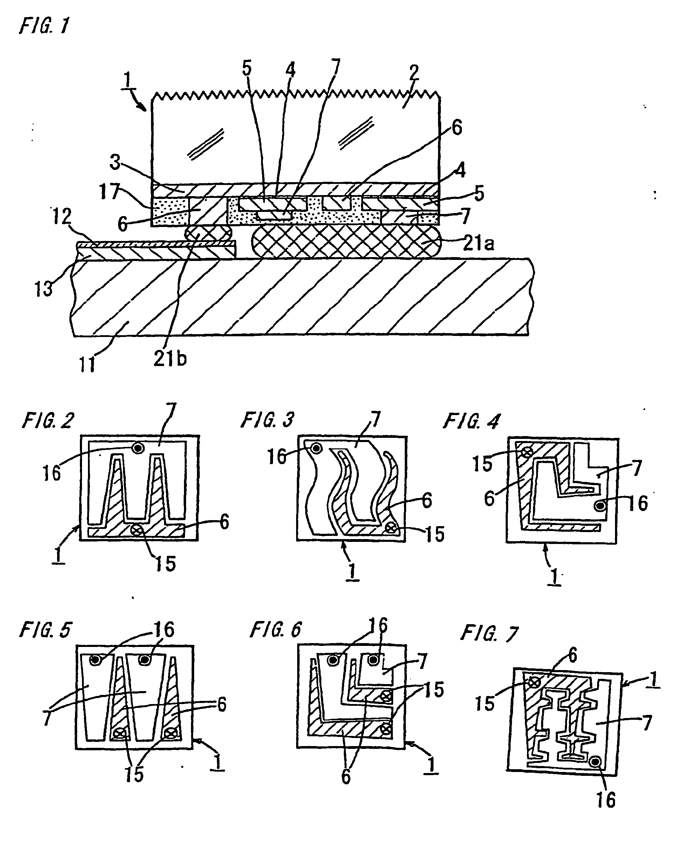

FIG. 1 shows a configuration of a light emitting device according to this embodiment, and FIG. 2 shows an example of electrode arrangement of an LED chip in the light emitting device not forming part of the present invention. In FIG. 1, like components are denoted by like numerals as those of FIG. 40.

The light emitting device comprises an LED chip 1 and a circuit board (mounting board) having, as the base material, a conductive plate on which the chip 1 is mounted. The conductive plate is selected from metal plates that are good thermal and electric conductors, for example, an aluminum plate. An electrically conductive layer 12 is provided over part of the LED chip 1 mounting side of the conductive plate, with an insulating layer 13 therebetween. The electrically conductive layer 12 constructs a wiring pattern, and its upper surface is plated with gold. The LED chip 1 includes a light-transmissive substrate 2 (sapphire substrate or the like), an n-type semiconductor layer 3 (a first semiconductor layer) formed on the substrate, a p-type semiconductor layer 5 (a second semiconductor layer) formed on the n-type semiconductor layer, and an n-side electrode 6 (a first electrode) and a p-side electrode 7 (a second electrode) each provided at the semiconductor layer side of the LED chip 1 and connected to the corresponding layer. The joining portion between the two semiconductor layers 3 and 5 is a light emitting layer 5.

The LED chip 1 is mounted face down on the circuit board. More particularly, one electrode (the p-side electrode 7 in FIG. 1) of the LED chip 1 is located adjacent to the main surface while the other electrode (the n-side electrode 6 in FIG. 1) is disposed adjacent to the sapphire substrate by removing the main surface partially. Then, a soldering bump 21a is formed for the one electrode adjacent to the main surface while a gold bump 21b is formed for the other electrode adjacent to the sapphire substrate. The area of the one electrode exposed from the main surface is configured larger enough than that of the other electrode adjacent to the sapphire substrate, and the one electrode is connected to the conductive plate 11 with the bump 21a. The other electrode adjacent to the sapphire substrate is connected to the electrically conductive layer 12 with the bump 21b. In addition, a thin metal film for ease of joining between the bump 21a and an insulating thin film 17 is applied to the outside area of the insulating thin film 17 that is in contact with the bump 21a, although it is not shown in FIG. 1. In the arrangement, as shown in FIG. 2, the p-side electrode 7 and the n-side electrode 6 are configured like combs facing each other in the semiconductor layer side (semiconductor active side) of the LED chip 1, and they have parallel aligned potions that are arranged alternately at substantially regular intervals. The electrodes 6 and 7 are supplied with power at respective feeding points 15 and 16 provided at their ends facing each other. The electrodes 6 and 7 and their feeding points 15 and 16 are deposited by evaporation of gold or aluminum, for example. The n-side electrode 6 connected to the n-type semiconductor layer adjacent to the light-transmissive substrate is configured to become narrower as the distance from its feeding point increases. In an electrode, as the distance from the feeding point increases, the current density required to cause an adjacent light emitting layer to emit a specific quantity of light decreases. Therefore, if the n-side electrode is decreased in width in proportion to the decrease of required current density, it becomes possible to increase the area of the p-type semiconductor layer connected with the p-side electrode facing it and the area of the light emitting layer located under it. This permits the LED chip 1 to have increased light-emitting area and thus the efficiency of light emission can be further enhanced. Since the electrodes 6 and 7 are configured to be broad enough to cover the whole area of the semiconductor layer side chip surface of the LED chip 1, they can serve as a reflector for light radiated from the chip surface.

The light-trasmissive substrate 2 has about 1µm roughness formed at the side opposite the semiconductor layer or gallium nitride layer side. In this embodiment, the roughness is formed by polishing the back side with an abrasive having an appropriate size of grain. The cross section of the roughness may be triangular, rectangular, semicircular, and so on.

In this light emitting device, components of the light emitted from the light emitting portion of the gallium nitride layer that are directed downward can be mostly reflected on the electrodes 6 and 7 to be directed upward. Components of the light emitted from the light emitting portion that are directed upward pass through the light-transmissive substrate 2 to reach its upper surface. The roughness formed at the upper surface acts as substantially a perfect diffuser. Thus, the light is mostly forwarded to the outside and partially reflected to be redirected downward in the light-trasmissive substrate 2. However, since the reflection is on the roughened surface, the direction is random. The light reflected on the roughened surface partially reaches the side surface of the light-transmissive substrate 2, through which it is forwarded to the outside. Some components of the light reflected on the roughened surface that reach the under surface are reflected again on the electrodes 6 and 7 toward the upper surface and mostly forwarded from the roughened surface to the outside. As described, the LED chip 1 is mounted face down on the mounting board and has the upper surface provided with the roughness. This can reduce parallel surfaces in the LED chip, thus preventing repeated total internal reflection of light.

In the configuration described above, the LED chip 1 can be thermally coupled at its relatively large area with the conductive plate 11 through the bump 21a. Solder is relatively high in the thermal conductivity, and moreover the cross section of the bump 21a is relatively large. This makes it possible to efficiently transfer heat from the LED chip 1 to the conductive plate. That is, the bump 21a in this embodiment functions as a heat transfer medium between the LED chip 1 and the conductive plate 11. In this embodiment, the insulating thin film 17 covers the side of the LED chip 1 where the electrodes are formed, except the feeding points. In such a case, even if the bump 21a is relatively large, a short circuit does not happen unless the bump 21a becomes in direct contact with the bump 21b or the corresponding electrode. Accordingly, the large bump 21a can be provided to either electrode.

The bump 21a is not limited to the solder but may be made of another material that is high in the thermal conductivity, e.g. Ag paste. Further, in place of the single large bump 21a, a plurality of small bumps may be arranged at the same portion for joining the LED chip 1 with the conductive plate 11. Such an arrangement can realize a similar effect of thermal transmission. The plurality of bumps may be adhered to the outer surface of the insulating thin film 17 with the thin metal film applied, similar to the bump 21a. However, if the insulating thin film 17 is partially removed by e.g. etching to expose the main surface side electrode 7 and the bumps are directly adhered to the electrode 7, the thermal resistance across the LED chip 1 and the conductive plate 11 can be further reduced, and thus the effect of heat radiation can be improved.

Preferably, the LED chip 1 mounted on the circuit board and its surrounding are sealed with a synthetic resin capable of transmitting light. As described above, since the LED chip 1 is thermally connected to the conductive plate 11 with the bump 21 a, heat generated by the LED chip 1 can be radiated through the conductive plate 11. Accordingly, the effect of heat radiation can be remarkably enhanced as compared with conventional structure, and the temperature of the LED chip 1 when turned on can be kept lower than that in the conventional structure.

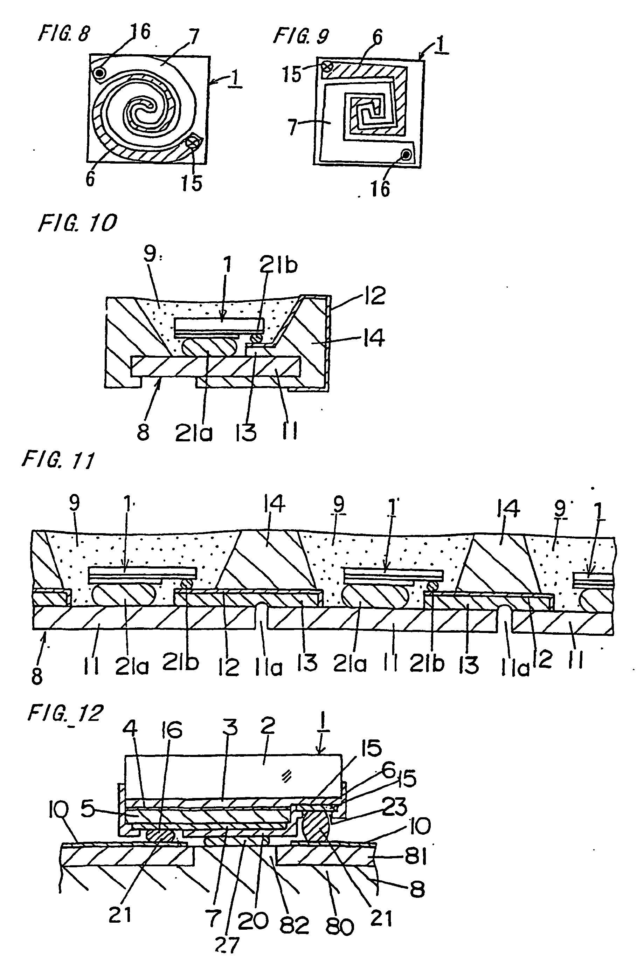

As shown in FIG. 10, the LED chip 1 is surrounded by a reflector 14 made of an insulating material, part of which is used as an insulating layer 13. This enables the control of distribution of light from the LED chip 1, thus permitting the light to be used efficiently. The reflector 14 becomes greater in the inner diameter as departing from the LED chip 1, and the inside of the reflector 14 is filled with a sealing resin 9 of light-transmissive synthetic resin.

In FIG. 10, the single LED chip 1 is mounted on the single mounting board (circuit board) 8. Alternatively, as shown in FIG. 11, the single mounting board 8 may be configured by a plurality of conductive plates 11 so that each of the conducting plate 11 is provided with at least one LED chip 1. In such a configuration, adjacent conductive plates 11 are connected with each other by an insulating layer 13. More specifically, one electrode of an LED chip 1 mounted on one of the adjacent conductive plates 11 is electrically connected with the other conductive plate through an electrically conductive layer 12 formed on the surface of the insulating layer 13. Additionally, a reflector 14 is located above the insulating layer 13 at the area between the adjacent conductive plates 11. Such a configuration can be realized by forming the insulating layer 13 on a single metal plate and then giving a separating groove 11a, with a cutting tool, at the back side of the metal plate (the side opposite the LED chip 1) so as to provide the conductive plates 11 electrically isolated from each other. This configuration permits a plurality of LED chips 1 to be connected in series.

In this embodiment, the reflector 14 and the sealing resin 9 are not essential components. For example, a reflector 14 may be provided separately. Even without the reflector 14 and the sealing resin 9, the LED chip 1 can be improved in the effect of heat radiation while the temperature of the LED chip 1 when turned on can be kept lower, as compared to conventional structure. As a result, the light emitting device can provide increased light output without declining its operating life, or if the light output is remaining unchanged, the operating life can be improved as compared with conventional structure.

When the reflector 14 is configured to surround part of the conductive plate 11 as shown in FIG. 10, the insulating layer 13 is preferably made of e.g. synthetic resin or ceramics, on which a circuit board having three-dimensional structure (MID board) is provided. In this configuration, a conductive layer 12 is disposed with three-dimensional structure so as to be extended to the surface of the conductive plate 11 opposite the LED chip 1. This configuration makes it easy to join the light emitting device having the LED chip 1 mounted on the circuit board 8 with the circuit board of an external circuit by soldering or caulking

When current is applied to the feeding points 15 and 16 shown in FIG. 2 to turn on the LED chip 1, a light-emitting portion is generated in the area between the two linear electrodes 6 and 7 that face each other in parallel. As a result, it has turned out that the single LED chip 1 has a multi-lighting area including a plurality of light-emitting portions, which permitting the light-emitting surface of the LED chip 1 to emit light with a substantially uniform intensity. Additionally, light radiated toward the mounting board 8 reaches the electrodes 6 and 7 for reflection to the light-transmissive substrate 2 side, that is, to a light extraction direction. This can enhance the light extraction efficiency, thus providing the LED chip 1 improved in the efficiency of light emission.

FIG. 2 shows a configuration of linear electrodes 6 and 7 arranged in parallel FIG. 3 shows wavy curved electrodes 6 and 7 arranged in parallel not forming part of the present invention. Such electrodes 6 and 7 has also proved to be capable of forming the multi-lighting area described above.

FIG. 4 shows L-shaped electrodes 6 and 7 arranged in parallel not forming part of the present invention. Such electrodes 6 and 7 has also proved to be capable of forming the multi-lighting area described above.

FIG. 5 shows linear electrodes 6 and 7, similar to those shown in FIG. 2, arranged in parallel and alternately at regular intervals. In this case, an LED chip 1 does not have an electrically conductive portion for electrically connecting a pair of electrodes 6 and 6, or 7 and 7, which are provided on the corresponding semiconductor layer, with each other, but each of the electrodes 6, 6, 7, and 7 has an individual feeding point 15 or 16. When the LED chip 1 having this electrode structure is turned on, since the LED chip 1 is provided with no portion for electrical connection between the electrodes, it decreases in the ratio of electrically conductive portions (electrodes) that are not parallel to each other. Accordingly, with the light-emitting portions emitting light uniformly, the light-emitting surface of the LED chip 1 can emit light still more uniformly as compared to that using the electrodes shown in FIG. 2. The linear electrodes 6 and 7 may be replaced with curved ones. Alternatively, L-shaped electrodes 6 and 7 as shown in FIG. 6 may be used for similarly uniform emission of light.

FIG. 7 shows electrodes not forming part of the present invention similar to those shown in FIG. 2 that are modified in that each of the electrodes 6 and 7 has branches formed integrally with trunks and extending toward an electrode parallel thereto. The branches of one of the parallel electrodes 6 and 7 are arranged to be parallel to those of the other. In this case, as compared to the electrodes shown in FIG. 2, the distance between the electrodes 6 and 7 that face each other decreases while the density of portions of the electrodes 6 and 7 that face each other increases in the light-emitting surface. Accordingly, when turned on, the LED chip 1 can have light-emitting portions with high density (multi-lighting area), and thus the light-emitting surface of the LED chip 1 can be further improved in the uniformity of light emission.

FIG. 8 shows a pair of electrodes 6 and 7 arranged to be spiral not forming part of the present invention, in parallel to each other, from the center of an LED chip 1 toward the edges so that the LED chip 1 has a plurality of portions where the electrodes are parallel to each other from the center to the edges. The spiral arrangement can reduce the portions where the electrodes are not parallel to each other, thus permitting the whole light-emitting surface to emit light with a still more uniform intensity. The configuration of the spiral is not limited to the curve but may be a straight line not forming part of the present invention as shown in FIG. 9.

### (Embodiment 2)

FIG. 12 shows a light emitting device according to this embodiment. This embodiment employs the electrode structure as shown in FIG. 2. An insulating thin film 20 is formed to cover a P-side electrode 7 and has openings 23 at the opposite ends. The electrode 7 is joined through the opening 23 to an electrically conductive material 10 of a mounting board 8 with a bump 21 of solder, gold, or other metal. The joining may be carried out by use of an electrically conductive adhesive. Further, an N-side electrode 6 is exposed from the opening 23 of the insulating thin film 20 at the other end. The exposed portion of the N-side electrode 6 serves as its feeding point 15 and is joined to the electrically conductive material 10 of the mounting board 8 with a bump 21 or an electrically conductive adhesive, similar to the feeding point 16 of the P-side electrode 7.

The mounting board 8 has a metal plate 80 as a base material. The metal plate 80 has an upper surface provided with a resin layer 81, on which the electrically conductive material 10 is formed. Part of the metal plate 80 is protruded to be exposed at a location corresponding to the insulating thin film 20 in the middle of an LED chip 1. A filler 27a of adhesive having high thermal conductivity is applied between this protrusion 82 and the insulating thin film 20. Thus, heat from the LED chip 1 can be radiated toward the metal plate 80. It is noted that the electrodes 6 and 7 serve as a reflector.

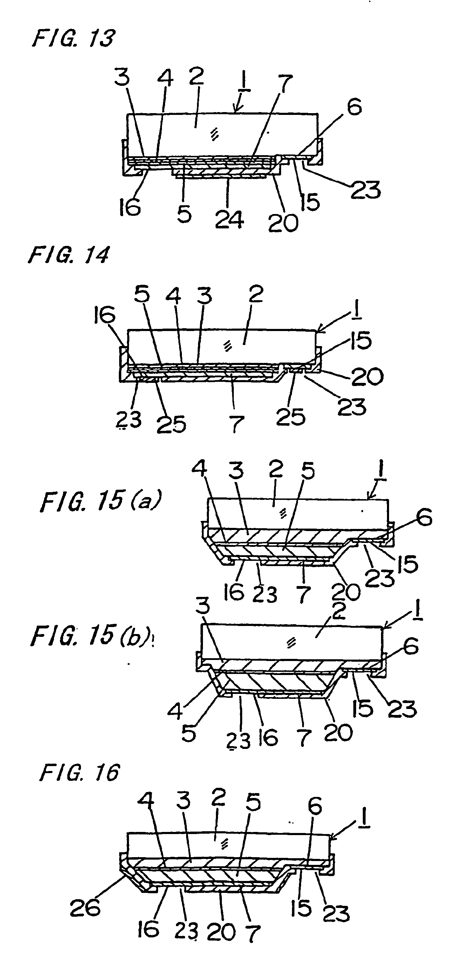

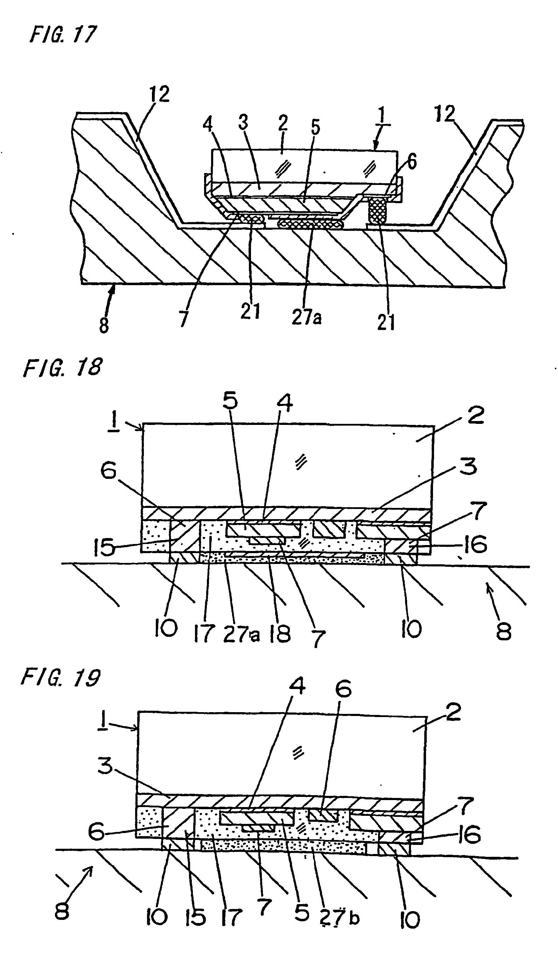

Instead of using the electrodes 6 and 7 as a reflector, a thin metal film 24 for reflecting light may be provided on the outer surface of middle part of the insulating thin film 20 as shown in FIG. 13. As shown in FIG. 14, a metal film 25 may be provided on the surface of the N-side electrode 6 and/or the P-side electrode 7 that is joined to the electrically conductive member 10 for ease of the joining. In the above structure, since the insulating thin film 20 surrounds the side surfaces of the LED chip 1 to the vicinity of a light emitting layer 4 at the mounting side, light from the periphery of the light emitting layer 4 can be reflected on the insulating thin film 20 of SiO2 and thus hindered from being released to the outside. To solve the problem, as shown in FIGS. 15a and 15b, semiconductor layers 3 and 5, and the light emitting layer 4 may be etched at their periphery so as to form inclined surfaces around the mounting side. Then, if the insulating thin film 20 is provided along the inclined surfaces, light emitted from the periphery of the light emitting layer 4 can be released to the outside. As shown in FIG. 17 for example, a reflector may be additionally provided at the inner wall of a recess of an external mounting board for directing the light in a light extraction direction so that the light can be used efficiently.

There may be cases where it is difficult to provide externally such a reflector for a good use of light released from the LED chip 1 as shown in FIG. 15 to the outside because the thickness from the chip surface to the light emitting layer 4 is very small. Therefore, as shown in FIG. 16, a reflecting film 26 or thin metal film may be formed on the outer surface of the insulating thin film 20 provided along the inclined surface, for directing light emitted from the periphery of the light emitting layer 4 toward a light-transmissive substrate 2.

### (Embodiment 3)

In Embodiment 1, the electrodes 6 and 7 are used as a reflector. In this embodiment, as shown in FIG. 18, an Ag vapor deposition film 18 as a reflector is formed on the outer surface of a light-transmissive insulating thin film 17 provided at the semiconductor layer side of an LED chip 1. When mounting the LED chip 1 on a mounting board 8, a filler 27a is applied between the Ag vapor deposition film 18 and the mounting board 8. For comparison, an LED chip has been made that does not include the Ag vapor deposition film 18 as a reflector, with the electrode structure similar to that in FIG. 18. As a result of mounting the two LED chips face down on the mounting board 8 and turning them on, it has turned out that this embodiment employing the Ag vapor deposition film 18 is superior in the efficiency of light emission.

### (Embodiment 4)

FIG. 19 shows this embodiment schematically. In Embodiment 3, a reflector is the Ag vapor deposition film 18 formed on the outer surface of the insulating thin film 17. In this embodiment, as shown in FIG. 19, the Ag vapor deposition film 18 is replaced with a filler 27b of Ag paste, which is applied to the space between an insulating thin film 17 and a mounting board 8 to be used as a reflector.

A sample has been made in which a similar LED chip is mounted on a mounting board 8 with a transparent resin incapable of reflecting light being used as a filler. As a result of comparison of the sample with this embodiment, this embodiment employing the filler 27b of Ag paste has turned out to be superior in the efficiency of light emission.

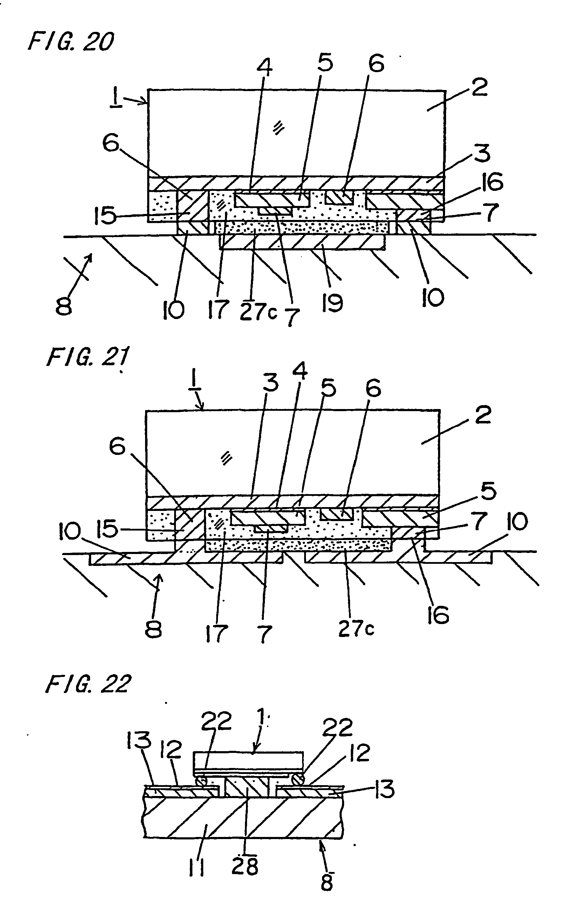

In FIG. 19, the Ag paste is applied as the filler 27b to the space between the insulating thin film 17 and the mounting board 8 so as to serve as a reflector. As an alternative, as shown in FIG. 20, a light-transmissive resin, e.g., an epoxy resin, may be applied as a filler 27c for mounting the LED chip 1 face down on the mounting board 8 while a shallow groove is provided in the surface of the mounting board 8 at a location corresponding to the LED chip 1 so that a mirror-finish metal plate 19 is fitted into the groove to be used as a reflector functioning similarly. Instead of providing the mounting board 8 with the groove, a thin metal plate may be adhered to the surface of the mounting board 8, or a thin metal film may be grown on the surface. In such a case, the metal plate or film can function as a reflector similar to the above.

An electrically conductive material 10 provided on the mounting board 8 in the vicinity of the LED chip 1 can be used as a part of the reflector. Alternatively, as shown in FIG. 21, when mounting an LED chip face down, the electrically conductive material 10 of a mounting board 8 may be extended to behind the LED chip 1 so as to be used as a reflector. For comparison, a sample has been made in which a similar LED chip 1 is mounted on a mounting board of which the electrically conductive material 10 is not extended to behind the LED chip 1. As a result, it has turned out that extending the electrically conductive material 10 to behind the LED chip 1 enhances the efficiency of light emission.

### (Embodiment 5)

In this embodiment, a mounting board 8 is provided with electrically conductive layers 12 connected to respective electrodes of an LED chip 1 as shown in FIG. 22. More specifically, the mounting board 8 has the electrically conductive layers 12 electrically isolated with an insulating layer 13 at the LED chip 1 mounting side, and each of the electrically conductive layers 12 is connected to the corresponding electrode of the LED chip 1. In this case, the surface of the LED chip 1 that faces a conductive plate 11 is protected by a silicon oxide coating while a heat transfer medium 28 made of a material high in the thermal conductivity (a silver plate for example) is provided between the LED chip 1 and the conductive plate 11.

Each of the electrodes of the LED chip 1 is connected with the corresponding electrically conductive layer 12 through an electrically conductive paste 22 (a silver paste for example). In this structure, with the electrically conductive paste 22 shrinking on hardening, the heat transfer medium 28 can be brought in tight contact to both the LED chip 1 and the conductive plate 11. In this embodiment, it is preferable that the LED chip 1 and its surrounding is sealed with a synthetic resin capable of light transmission. The synthetic resin can protect the LED chip 1 while enhancing the mechanical strength of connection between the LED chip 1 and the conductive plate 11. In place of the electrically conductive paste 22, a bump may be used in the same manner as Embodiment 1. This is also applicable to embodiments described below.

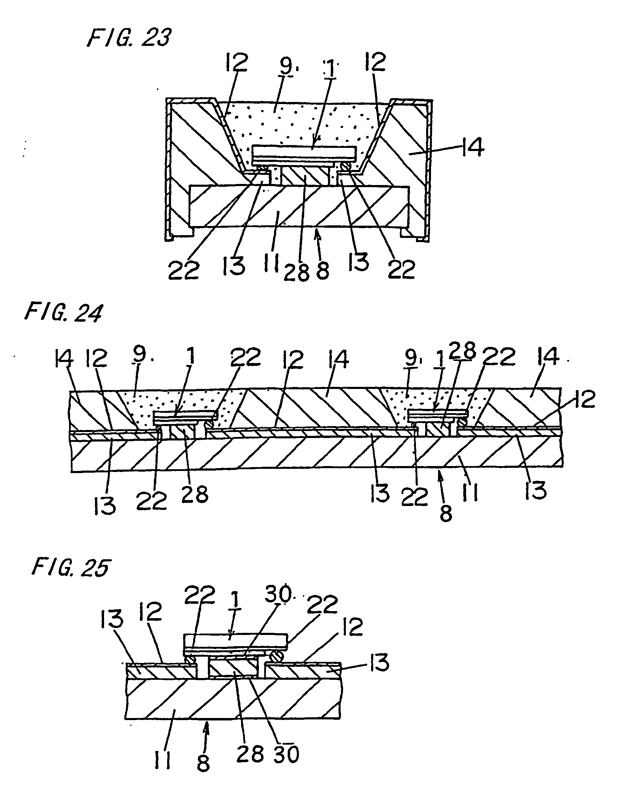

In this embodiment, a single LED chip 1 may be mounted on a single mounting board 8 as shown in FIG. 23, or a plurality of LED chips 1 may be mounted on a single mounting board 8 as shown in FIG. 24. In the latter case, an electrically conductive layer 12 is used as an electric circuit between the LED chips 1.

The heat transfer medium 28 is only in contact to the conductive plate 11 and to the LED chip 1 in the structure described above, but as shown in FIG. 25, the heat transfer medium 28 may be adhered to the conductive plate 11 and the LED chip 1 at the respective sides by use of an adhesive 30. Alternatively, the heat transfer medium 28 may be adhered to one of the two, i.e. the conductive plate 11 and the LED chip 1, with the adhesive 30 while it is only in contact to the other. Preferably, the adhesive 30 is made of solder or silver paste high in the thermal conductivity to enhance the effect of heat radiation. Alternatively, a synthetic resin for use in underfilling may be employed as an adhesive 30 if the thickness is reduced. In such a case, the LED chip 1 can be relatively well inhibited from rising its temperature.

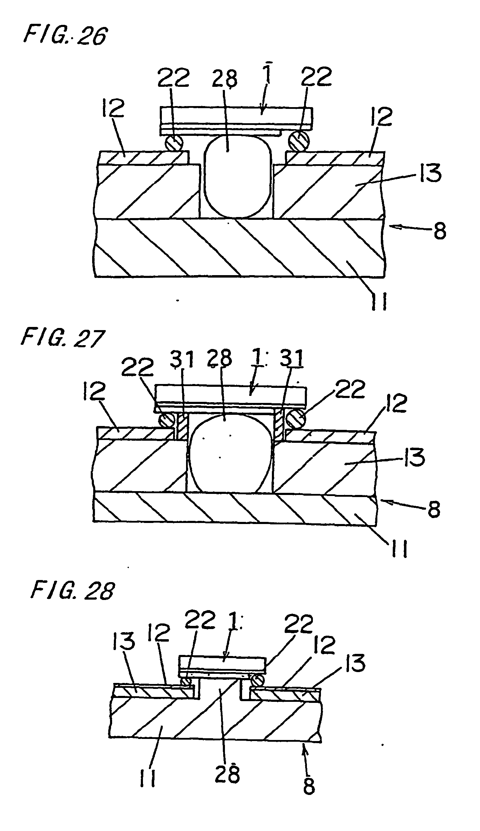

The heat transfer medium 28 is not limited to the silver plate used in this embodiment, but may be any material that is higher enough in the thermal conductivity than the insulating layer 13. For example, the heat transfer medium 28 may be made of a synthetic resin having metal powder high in the thermal conductivity dispersed therein. Alternatively, as shown in FIG. 26, solder may be used as the heat transfer medium 28. In such a case, by heating the solder for melting it, the solder as the heat transfer medium 28 can be stuck fast to the LED chip 1 and the conductive plate 11. Consequently, the heat transfer medium 28 can become in favorable contact with both the LED chip 1 and the conductive plate 11, thus reducing the thermal resistance across the LED chip 1 and the conductive plate 11 to improve the effect of heat radiation.

When the solder is used as the heat transfer medium 28, in view of the heating of the solder for melting it, any measure should be taken for preventing electrical connection between the electrode of the LED chip 1 and the solder (heat transfer medium 28). More particularly, it is necessary to prevent the melted solder (heat transfer medium 28) from adhering to the LED chip 1, the electrically conductive paste 22, or the electrically conductive layer 12. Therefore, as shown in FIG. 27, it is preferable that a barrier 31 made of an insulating material is provided between the electrode of the LED chip 1 and the solder as the heat transfer medium 28 in the space between the LED 2 and the conductive plate 11, in order to electrically isolate the heat transfer medium 28 from the electrically conductive paste 22 and the electrically conductive layer 12 (i.e. from the electrode of the LED chip 1). That is, the barrier 31 is configured to surround the heat transfer medium 28 of solder in the region between the electrodes of the LED chip 1 (electrically conductive pastes 22 and electrically conductive layers 12). The barrier 31 can inhibit the solder from electrically connecting with the electrode of the LED chip 1 when the solder is heated to be melted, thus reducing defective products. Preferably, the barrier 31 is made of ultraviolet cure type resin for ease of its formation.

Similar to Embodiment 1, this embodiment employs the LED chip 1 thermally coupled to the conductive plate 11. Accordingly, the LED chip is improved in the effect of heat radiation and thus its temperature rise is declined. The other arrangement and actions are identical to those of Embodiment 1.

When the reflector 14 is configured to surround part of the conductive plate 11 as shown in FIG. 23, the insulating layer 13 is preferably made of e.g. synthetic resin or ceramics, on which a circuit board having three-dimensional structure (MID board) is provided. In this configuration, a conductive layer 12 is disposed with three-dimensional structure so as to be extended to the surface of the conductive plate 11 opposite the LED chip 1. This configuration makes it easy to join the light emitting device having the LED chip 1 mounted on the circuit board 8 with the circuit board of an external circuit by soldering or caulking.

### (Embodiment 6)

In this embodiment, as shown in FIG. 28, a heat transfer medium 28 similar to that in Embodiment 5 is formed integrally with a conductive plate 11 so as to be projected upward. Since this embodiment does not need the heat transfer medium 28 provided separately from the conductive plate 11 while the other arrangement is identical to that of Embodiment 5, the number of components can be decreased.

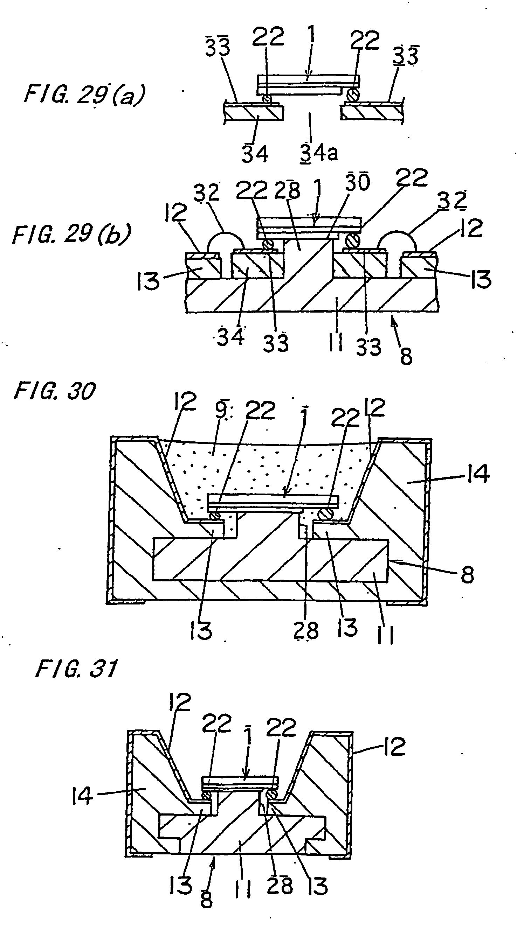

In order to cause the upper surface of the heat transfer medium 28 integrated with the conductive plate 11 to come in contact with an LED chip 1, the shrinkage on hardening of an electrically conductive paste may be used similar to Embodiment 5. Alternatively, the contact can be realized by using the construction as shown in FIG. 29. In this case, as shown in FIG. 29a, an insulating plate 34 having an electrically conductive layer 33 on one side is provided separately from a mounting board 8. The insulating plate 34 has a through hole 34a for receiving a heat transfer medium 28. The LED chip 1 is mounted on the electrically conductive layer 33 before the heat transfer medium 28 of the conductive plate 11 is inserted into the through hole 34a of the insulating plate 34 as shown in FIG. 29b. The upper surface of the heat transfer medium 28 is adhered to the LED chip 1 with an adhesive 30. Preferably, the adhesive 30 is solder or silver paste that is high in the thermal conductivity. The mounting board 8 has an electrically conductive layer 12, which is electrically connected to the electrically conductive layer 33 on the insulating plate 34 through a bonding wire 32. In the figure, the electrode of the LED chip 1 is connected to the electrically conductive layer 33 with an electrically conductive paste 22, which may be replaced by a bump of gold or solder, similar to Embodiment 1. It is noted that the conductive plate 11 is joined to a reflector 14 by prepreg or the like.

Similar to Embodiment 1, an insulating layer 13 can be formed integrally with the reflector 14. Accordingly, if the conductive plate 11 is embedded in the reflector 14 as shown in FIG. 30, it can be held by the reflector 14. Alternatively, as shown in FIG. 31, the conductive plate 11 may be partially embedded in the reflector 14 while it is exposed from the reflector 14 at the back side (the surface opposite the LED chip 1). This structure can improve the effect of heat radiation while the conductive plate 11 is held by the reflector 14 similar to the structure as shown in FIG. 30.

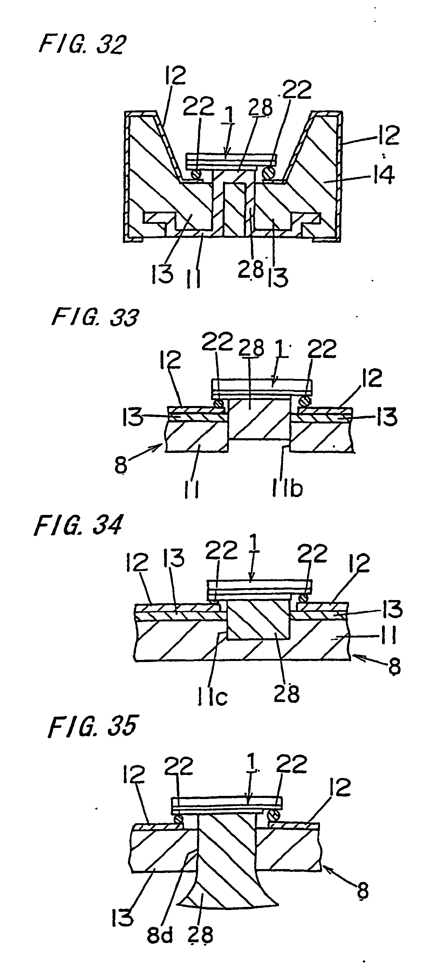

In FIG. 32, a conductive plate 11 is made of sheet metal and subjected to bending to shape a heat transfer medium 28. The conductive plate 11 is mostly embedded in a reflector 14 while partially exposed from the back side of the reflector 14. This structure can also ensure the effect of heat radiation. The other arrangement and actions are identical to those in Embodiment 5.

Methods of forming a heat transfer medium 28 integral with a conductive plate 11 include, besides machining, embossing press for developing a recess 11b at the back side of a conductive plate 11 as shown in FIG. 33, and providing the front surface of a conductive plate 11 with a recess 11c for engaging with a heat transfer medium 28 as shown in FIG. 34.

When the reflector 14 is configured to surround part of the conductive plate 11 as shown in FIGS. 30 and 31, the insulating layer 13 is preferably made of e.g. synthetic resin or ceramics, on which a circuit board having three-dimensional structure (MID board) is provided. In this configuration, a conductive layer 12 is disposed with three-dimensional structure so as to be extended to the surface of the conductive plate 11 opposite the LED chip 1. This configuration makes it easy to join the light emitting device having the LED chip 1 mounted on the circuit board 8 with the circuit board of an external circuit by soldering or caulking.

### (Embodiment 7)

In the above embodiments, the heat transfer medium 28 is thermally coupled to the conductive plate 11. On the other hand, the light emitting device according to this embodiment has a heat transfer medium 28 but does not have a conductive plate 11 as shown in FIG. 35, and it employs a printed circuit board of glass epoxy as a mounting board 8. More particularly, the mounting board 8 is a single-sided printed circuit board including an insulating layer 13 and an electrically conductive layer 12 laid thereon. It is noted that the electrically conductive layer 12 is made of gold in view of joining with the electrode of an LED chip 1. The mounting board 8 has a through hole 8d, in which a pin-shaped heat transfer medium 28 is inserted. The heat transfer medium 28 is thermally coupled to the LED chip 1 at one end. The heat transfer medium 28 arranged in such a manner is unable to provide the sufficient effect of heat radiation by itself. However, if the other end of the heat transfer medium 28 opposite the LED chip 1 is brought in contact to a member capable of effective heat radiation that is provided in the housing of an apparatus, the sufficient effect of heat radiation can be secured. That is, in this embodiment, the insulating layer 13 is arranged between the electrically conductive layer 12 and the member to be in contact with the heat transfer medium 28, which can function as a conductive plate. Preferably, the heat transfer medium 28 is made of a material high in the thermal conductivity, for example, aluminum.

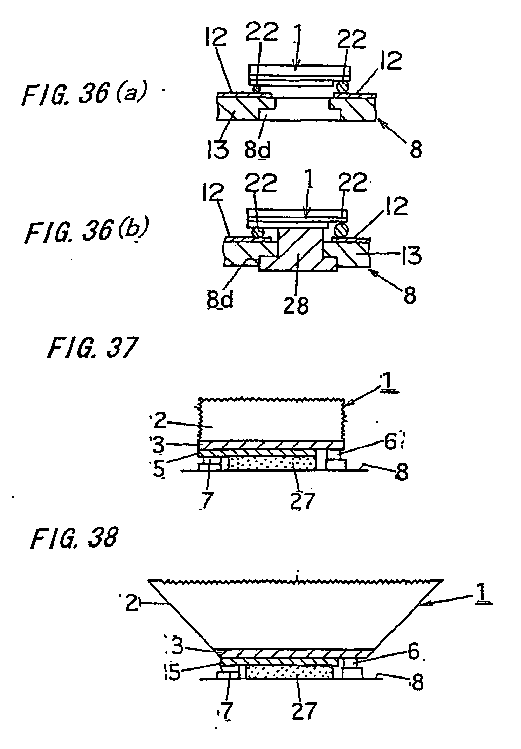

In order to secure the contact between the LED chip 1 and the heat transfer medium 28 in this embodiment, it is preferable that the LED chip 1 is mounted on the mounting board 8 as shown in FIG. 36a before the heat transfer medium 28 is inserted into the through hole 8d of the mounting board 8 for joining to the under surface of the LED chip 1 as shown in FIG. 30b. Preferably, solder or silver paste that is a good thermal conductor is used as the adhesive. The other arrangement and functions are identical to those of the above described embodiments.

The conductive plate 11 is not limited to the aluminum plate used in the above described embodiments, but may be made of any material that is a thermal and electric conductor, gold for example. The electrically conductive layer 12 may be made of any good electric conductor, silver, copper or the like, in place of gold. The LED chip 1 is not limited to that as used in the embodiments, i.e. an LED chip including a light-transmissive substrate and gallium nitride group light emitting layers formed thereon, but the LED chip 1 may be modified if it has a substrate capable of transmitting light and can be mounted face down.

### (Embodiment 8)

FIG. 37 shows an LED chip according to this embodiment. This LED chip 1 is a gallium nitride group LED formed on a light-transmissive substrate 2, similar to those in the other embodiments. In this embodiment, the light-transmissive substrate 2 of the LED chip 1 has roughness at the side surfaces as well as at the surface opposite the gallium nitride layer. When this LED chip 1 is mounted face down on a mounting board 8, not only the roughened upper surface but also the roughened side surfaces can decrease parallel surfaces in the LED chip. This can further prevent the repeated total internal reflection of light within the LED chip 1, thus increasing the light extraction efficiency.

### (Embodiment 9)

FIG. 38 shows an LED chip according to this embodiment. This LED chip 1 is a gallium nitride group LED formed on a light-transmissive substrate 2, similar to those in the other embodiments. In this embodiment, the light-transmissive substrate 2 has a trapezoidal cross section, and it is provided with about 1µm roughness at the surface opposite the gallium nitride layer. The side surfaces of the light-transmissive substrate 2 are cut off at an angle of 60° with respect to the surface of the gallium nitride layer. In the LED chip 1 according to this embodiment, since each of the side surfaces of the light-transmissive substrate 2 is configured to be an inverted trapezoid with an angle of 60°, they are not parallel with each other. Accordingly, the repeated total internal reflection of light within the LED chip 1 can be prevented, and thus the light extraction efficiency can be enhanced.

### (Embodiment 10)

FIG. 39 shows a light emitting device according to this embodiment. In this embodiment, an LED chip is used that is similar to that in Embodiment 8 and emits blue color light. A mounting board 8 has a recess, in which this blue color light emission type LED chip 1 is disposed. The recess is filled with an epoxy resin 9 having fluorescent particles dispersed therein for developing yellow color light that is complementary to the blue color light emitted from the LED chip 1.

Since the LED chip 1 in this embodiment permits light to be efficiently released from each of the roughened upper and side surfaces, the external quantum efficiency of blue color light emission can be enhanced extremely. The blue color light partially passes through the epoxy resin 9 to be released from the recess of the mounting board 8 while it is partially shifted to yellow color light with the fluorescent particles to be released from the recess. The blue color light and the yellow color light each released from the recess are combined to develop white color light. Thus, the light emitting device according to this embodiment can be enhanced in the efficiency of light extraction from the LED chip 1 while enhanced in the effect of heat radiation owing to its light emitting area arranged in the vicinity of the bottom of the recess of the mounting board 8, as compared with a conventional device that has a flat-surface light-transmissive substrate and uses a face up mounting.

The present invention is not limited to the above described embodiments, but other modifications may be made. For example, in the embodiments, the n-type semiconductor layer 3 (first semiconductor layer) is arranged closer to the light-transmissive substrate 2 than the p-type semiconductor layer (second semiconductor layer) 5 is. The two semiconductor layers may be arranged in the inverted order.

## Claims

1. A light emitting device comprising a light emitting diode chip (1), the light emitting diode chip (1) including a light-transmissive substrate (2), a first semiconductor layer (3) formed on the light-transmissive substrate (2), a second semiconductor layer (5) formed on the first semiconductor layer (3), and first and second electrodes (6, 7) provided on the light emitting diode chip (1) side where the semiconductor layers (3, 5) are formed, the first electrode (6) being formed on the first semiconductor layer (3) and the second electrode (7) being formed on the second semiconductor layer (5), and the light emitting diode chip (1) being mounted face down on a mounting board (8),
wherein the first and second electrodes (6, 7) are configured to be broad enough to cover the whole surface area of the light emitting diode chip (1) side where the semiconductor layers (3, 5) are formed so that
the first and second electrodes (6, 7) function as a light reflector for light radiated from said light emitting diode chip surface area;
wherein the first and second electrodes (6, 7) have respective electrical power feeding points (15, 16); and
wherein the first and second electrodes (6, 7) become narrower with the distance from the respective electrical power feeding point (15, 16),
**characterised in that**,
a plurality of first electrodes (6) and a plurality of second electrodes (7) are formed on the respective first and second semiconductor layers (3, 5), wherein each of the plurality of first and second electrodes (6, 7) have individual electrical power feeding points (15, 16) and wherein each of the plurality of first and second electrodes (6, 7) become narrower with the distance from the respective electrical power feeding point (15, 16).

2. The light emitting device according to claim 1, wherein the plurality of first and second electrodes (6, 7) are arranged alternately in parallel with each other at the side where the semiconductor layers (3, 5) are formed.

3. The light emitting device according to claim 2, wherein the electrodes (6, 7) are arranged in parallel with each other at substantially regular intervals.

4. The light emitting device according to claim 2, wherein the first and second electrodes (6, 7) are configured in a comblike structure.

5. The light emitting device according to claim 1, further comprising a light reflecting member provided, on a surface of the light emitting diode chip (1), separately from the electrodes (6, 7).

6. The light emitting device according to claim 1, wherein either a surface of the mounting board (8) that faces the light emitting diode chip (1) or a filler applied to a space between the light emitting diode chip (1) and the mounting board (8) functions as a light reflector.

7. The light emitting device according to claim 1,wherein the mounting board (8) is a circuit board including an elctrically conductive plate (11) having at least one surface provided with an electrically insulating layer (13) and an electrically conductive layer (12) provided over the electrically conductive plate (11) with the electrically insulating layer (13) therebetween; and wherein at least one of the electrodes (6, 7) of the light emitting diode chip (1) is electrically connected to the electrically conductive layer (12) by the face down mounting, and a heat transfer medium (28) that is higher in thermal conductivity than the electrically insulating layer (13) is disposed between the light emitting diode chip (1) and the electrically conductive plate (11).

8. The light emitting device according to claim 7, wherein each of the electrodes (6, 7) of the light emitting diode chip (1) is electrically connected to a respective electrically conductive layer (12).

9. The light emitting device according to claim 7, wherein the heat transfer medium (28) is formed integral with the electrically conductive plate (11).

10. The light emitting device according to claim 7, wherein the heat transfer medium (28) is made of a metal.

11. The light emitting device according to claim 7, wherein the electrically conductive layer (12) is partially extended to the surface of the circuit board (8) opposite the light emitting diode chip (1), for connection to an external circuit.

12. The light emitting device according to claim 1, wherein the light-transmissive substrate (2) of the light emitting diode chip (1) has a roughened surface.

13. The light emitting device according to claim 12, wherein side surfaces of the light-transmissive substrate (2) of the light emitting diode chip (1) are cut at an oblique angle and serve as a mirror.

## Patentansprüche

1. Lichtemittierende Vorrichtung mit einem lichtemittierende Diodenchip (1), wobei der lichtemittierende Diodenchip (1) ein lichtdurchlässiges Substrat (2), eine erste Halbleiterschicht (3), die auf dem lichtdurchlässigen Substrat (2) ausgebildet ist, eine zweite Halbleiterschicht (5), die auf der ersten Halbleiterschicht (3) ausgebildet ist, und erste und zweite Elektroden (6, 7) umfasst, die an der Seite des lichtemittierenden Diodenchips (1) vorgesehen sind, auf der die Halbleiterschichten (3, 5) ausgebildet sind, wobei die erste Elektrode (6) auf der ersten Halbleiterschicht (3) und die zweite Elektrode (7) auf der zweiten Halbleiterschicht (5) ausgebildet ist, und der lichtemittierende Diodenchip (1) mit der Vorderseite nach unten auf einer Trägerplatine (8) angebracht ist,
wobei die ersten und zweiten Elektroden (6, 7) so gestaltet sind, dass sie breit genug sind, um den gesamten Flächenbereich der Seite des lichtemittierenden Diodenchips (1) zu bedecken, an der die Halbleiterschichten (3, 5) ausgebildet sind, so dass
die ersten und zweiten Elektroden (6, 7) als Lichtreflektor für Licht fungieren, das von dem Flächenbereich des lichtemittierenden Diodenchips abgestrahlt wird;
wobei die ersten und zweiten Elektroden (6, 7) jeweilige Stromeinspeisepunkte (15, 16) aufweisen; und
wobei die ersten und zweiten Elektroden (6, 7) mit zunehmendem Abstand vom jeweiligen Stromeinspeisepunkt (15, 16) schmäler werden,
**dadurch gekennzeichnet, dass**
mehrere erste Elektroden (6) und mehrere zweite Elektroden (7) auf der ersten bzw. zweiten Halbleiterschicht (3, 5) ausgebildet sind, wobei jede der mehreren ersten und zweiten Elektroden (6, 7) einzelne Stromeinspeisepunkte (15, 16) haben und wobei jede der mehreren ersten und zweiten Elektroden (6, 7) mit zunehmendem Abstand vom jeweiligen Stromeinspeisepunkt (15, 16) schmäler werden.

2. Lichtemittierende Vorrichtung nach Anspruch 1, wobei die mehreren ersten und zweiten Elektroden (6, 7) abwechselnd parallel zueinander auf der Seite angeordnet sind, an der die Halbleiterschichten (3, 5) ausgebildet sind.

3. Lichtemittierende Vorrichtung nach Anspruch 2, wobei die Elektroden (6, 7) parallel zueinander mit im Wesentlichen gleichmäßigen Abständen angeordnet sind.

4. Lichtemittierende Vorrichtung nach Anspruch 2, wobei die ersten und zweiten Elektroden (6, 7) in einer kammartigen Struktur konfiguriert sind.

5. Lichtemittierende Vorrichtung nach Anspruch 1, darüber hinaus ein lichtreflektierendes Element umfassend, das auf einer Oberfläche des lichtemittierenden Diodenchips (1) separat von den Elektroden (6, 7) vorgesehen ist.

6. Lichtemittierende Vorrichtung nach Anspruch 1, wobei eine Oberfläche der Trägerplatine (8), die dem lichtemittierenden Diodenchip (1) zugewandt ist, oder ein Füllteil, das in einem Raum zwischen dem lichtemittierenden Diodenchip (1) und der Trägerplatine (8) angebracht ist, als Lichtreflektor dient.

7. Lichtemittierende Vorrichtung nach Anspruch 1, wobei es sich bei der Trägerplatine (8) um eine Platine mit einer elektrisch leitfähigen Platte (11) handelt, von der zumindest eine Oberfläche mit einer elektrisch isolierenden Schicht (13) und einer elektrisch leitfähigen Schicht (12) versehen ist, die über der elektrisch leitfähigen Platte (11) vorgesehen ist, wobei die elektrisch isolierende Schicht (13) dazwischen liegt; und wobei mindestens eine der Elektroden (6, 7) des lichtemittierenden Diodenchips (1) durch die Montage mit der Vorderseite nach unten elektrisch an die elektrisch leitfähige Schicht (12) angeschlossen ist, und ein Wärmeübertragungsmittel (28), das eine höhere Wärmeleitfähigkeit hat als die elektrisch isolierende Schicht (13), zwischen dem lichtemittierenden Diodenchip (1) und der elektrisch leitfähigen Platte (11) angeordnet ist.

8. Lichtemittierende Vorrichtung nach Anspruch 7, wobei jede der Elektroden (6, 7) des lichtemittierenden Diodenchips (1) elektrisch an eine jeweilige elektrisch leitfähige Schicht (12) angeschlossen ist.

9. Lichtemittierende Vorrichtung nach Anspruch 7, wobei das Wärmeübertragungsmittel (28) einstückig mit der elektrisch leitfähigen Platte (11) ausgebildet ist.

10. Lichtemittierende Vorrichtung nach Anspruch 7, wobei das Wärmeübertragungsmittel (28) aus einem Metall besteht.

11. Lichtemittierende Vorrichtung nach Anspruch 7, wobei sich die elektrisch leitfähige Schicht (12) teilweise bis zur Oberfläche der Platine (8) gegenüber dem lichtemittierenden Diodenchip (1) erstreckt, um an eine externe Schaltung angeschlossen zu werden.

12. Lichtemittierende Vorrichtung nach Anspruch 1, wobei das lichtdurchlässige Substrat (2) des lichtemittierenden Diodenchips (1) eine aufgeraute Oberfläche hat.

13. Lichtemittierende Vorrichtung nach Anspruch 12, wobei Seitenflächen des lichtdurchlässigen Substrats (2) des lichtemittierenden Diodenchips (1) unter einem schrägen Winkel geschnitten sind und als Spiegel dienen.

## Revendications

1. Dispositif électroluminescent comprenant une puce de diode émettrice de lumière (1), la puce de diode émettrice de lumière (1) incluant un substrat laissant passer la lumière (2), une première couche semiconductrice (3) formée sur le substrat laissant passer la lumière (2), une seconde couche semiconductrice (5) formée sur la première couche semiconductrice (3) et des première et seconde électrodes (6, 7) prévues sur le côté de la puce de diode émettrice de lumière (1) où les couches semiconductrices (3, 5) sont formées, la première électrode (6) étant formée sur la première couche semiconductrice (3) et la seconde électrode (7) étant formée sur la seconde couche semiconductrice (5), et la puce de diode émettrice de lumière (1) étant montée face dirigée vers le bas sur une carte de montage (8),
dans lequel les première et seconde électrodes (6, 7) sont configurées de manière à être suffisamment larges pour couvrir la totalité de l'aire de surface du côté de la puce de diode émettrice de lumière (1) où les couches semiconductrices (3, 5) sont formées de telle sorte que les première et seconde électrodes (6, 7) fonctionnent en tant que réflecteur de lumière pour la lumière rayonnée depuis ladite aire de surface de puce de diode émettrice de lumière,
dans lequel les première et seconde électrodes (6, 7) comportent des points d'alimentation en puissance électrique respectifs (15, 16) ; et
dans lequel les première et seconde électrodes (6, 7) deviennent plus étroites lorsque la distance par rapport aux points d'alimentation en puissance électrique respectifs (15, 16) augmente,
**caractérisé en ce que** :
une pluralité de premières électrodes (6) et une pluralité de secondes électrodes (7) sont formées sur les première et seconde couches semiconductrices respectives (3, 5), dans lequel chacune de la pluralité de premières et secondes électrodes (6, 7) comportent des points d'alimentation en puissance électrique individuels (15, 16) et dans lequel chacune de la pluralité de premières et secondes électrodes (6, 7) devient plus étroite lorsque la distance par rapport au point d'alimentation en puissance électrique respectif (15, 16) augmente.

2. Dispositif électroluminescent selon la revendication 1, dans lequel les électrodes de la pluralité de premières et secondes électrodes (6, 7) sont agencées en alternance en parallèle les unes aux autres au niveau du côté où les couches semiconductrices (3, 5) sont formées.

3. Dispositif électroluminescent selon la revendication 2, dans lequel les électrodes (6, 7) sont agencées en parallèle les unes aux autres selon des intervalles sensiblement réguliers.

4. Dispositif électroluminescent selon la revendication 2, dans lequel les premières et secondes électrodes (6, 7) sont configurées selon une structure en forme de peigne.

5. Dispositif électroluminescent selon la revendication 1, comprenant en outre un élément réfléchissant la lumière prévu sur une surface de la puce de diode émettrice de lumière (1), séparément des électrodes (6, 7).

6. Dispositif électroluminescent selon la revendication 1, dans lequel soit une surface de la carte de montage de la puce de diode émettrice de lumière (1), soit un agent de remplissage appliqué dans un espace entre la puce de diode émettrice de lumière (1) et la carte de montage (8) fonctionne en tant que réflecteur de lumière.

7. Dispositif électroluminescent selon la revendication 1, dans lequel la carte de montage (8) est une carte de circuit incluant une plaque électriquement conductrice (11) comportant au moins une surface munie d'une couche électriquement isolante et une couche électriquement conductrice (12) prévue au-dessus de la plaque électriquement conductrice (11), la couche électriquement isolante (13) étant entre ; et dans lequel au moins l'une des électrodes (6, 7) de la puce de diode émettrice de lumière (1) est connectée électriquement à la couche électriquement conductrice (12) au moyen du montage face vers le bas, et un milieu de transfert thermique (28) qui présente une conductivité thermique supérieure à celle de la couche électriquement isolante (13) est disposé entre la puce de diode émettrice de lumière (1) et la plaque électriquement conductrice (11).

8. Dispositif électroluminescent selon la revendication 7, dans lequel chacune des électrodes (6, 7) de la puce de diode émettrice de lumière (1) est connectée électriquement à une couche électriquement conductrice respective (12).

9. Dispositif électroluminescent selon la revendication 7, dans lequel le milieu de transfert thermique (28) est formé d'un seul tenant avec la plaque électriquement conductrice (11).

10. Dispositif électroluminescent selon la revendication 7, dans lequel le milieu de transfert thermique (28) est réalisé en métal.

11. Dispositif électroluminescent selon la revendication 7, dans lequel la couche électriquement conductrice (12) est partiellement étendue jusqu'à la surface de la carte de circuit (8) opposée à la puce de diode émettrice de lumière (1), pour une connexion sur un circuit externe.

12. Dispositif électroluminescent selon la revendication 1, dans lequel le substrat laissant passer la lumière (2) de la puce de diode émettrice de lumière (1) comporte une surface rendue rugueuse.

13. Dispositif électroluminescent selon la revendication 12, dans lequel des surfaces latérales du substrat laissant passer la lumière (2) de la puce de diode émettrice de lumière (1) sont coupées selon un angle oblique et jouent le rôle de miroir.
